# EUROPEAN PATENT APPLICATION

(11) **EP 4 807 687 A1**
(43) Date of publication of application: **16.09.2026**
(21) Application number: 25861671.3
(22) Date of filing: 25.02.2025
(51) Int. Cl.: G06T 19/20

(54) **METHOD AND APPARATUS FOR VISUALLY DISPLAYING AND CONTROLLING HOME APPLIANCE IN SPACE**

(30) Priority: 24.01.2025 KR 20250011850
(71) Applicant: LG ELECTRONICS, INC., Seoul 07336 (KR)
(72) Inventor: LEE, Jihye, Seoul 07796 (KR); KIM, Su Jung, Seoul 07796 (KR); JUNG, Jaehee, Seoul 07796 (KR); CHOI, Hu Ran, Seoul 07796 (KR); KIM, Eun Jung, Seoul 07796 (KR)
(74) Representative: Schott, Jakob Valentin
(86) International application number: PCT/KR2025/002608
(87) International publication number: WO 2026/160524

(57) **Abstract**

The present invention relates to a method and device for visually displaying and controlling home appliances in a space, and a device according to one embodiment of the present invention includes a communication unit configured to receive state information of a home appliance from the home appliance or a server, a control unit configured to generate an overall view or a detail view including a plan view of a space in which the home appliance is disposed and state information of the home appliance disposed in the space, and an interface unit configured to output the overall view or the detail view.

## Description

### [Technical Field]

The present invention relates to a method and device for visually displaying and controlling home appliances in a space.

### [Description of the Related Art]

As home appliances are increasingly disposed in spaces, the need to control the home appliances or monitor states of the home appliances is increasing. In particular, the need for remote monitoring and control to check the states and control of home appliances disposed in homes, offices, or the like is increasing.

However, home appliances are disposed in specific spaces, move in specific spaces, or operate to affect various environments within spaces, making the physical locations, arrangement, and the like of the home appliances within the spaces an important factor.

Accordingly, a method and device for visually controlling home appliances disposed in a space will be described.

### [Disclosure]

### [Technical Problem]

The present specification is directed to implementing a method and device for visually displaying a space in which home appliances are disposed, checking states of the home appliances disposed in the corresponding space, and controlling operations of the home appliances.

In addition, the present specification is directed to implementing a method and device for managing home appliances in groups to effectively monitor states of the home appliances.

In addition, the present specification is directed to providing various control methods for home appliances disposed in spaces by checking states of home appliances in detail for each space while comprehensively viewing the entire space.

Objects of the present invention are not limited to the above objects, and other objects and advantages of the present invention that are not described can be understood by the following description and will be more clearly understood by embodiments of the present invention. In addition, it will be able to be easily seen that the objects and advantages of the present invention may be achieved by devices and combinations thereof that are described in the claims.

### [Technical Solution]

According to one embodiment of the present invention, there is provided a device including a communication unit configured to receive state information of a home appliance from the home appliance or a server, a control unit configured to generate an overall view or a detail view including a plan view of a space in which the home appliance is disposed and state information of the home appliance disposed in the space, and an interface unit configured to output the overall view or the detail view.

According to one embodiment of the present invention, there is provided a method of visually displaying and controlling home appliances in a space, including receiving, by a communication unit of a device, state information of a home appliance from the home appliance or a server, generating, by a control unit of the device, an overall view or a detail view including a plan view of a space in which the home appliance is disposed and state information of the home appliance disposed in the space, and outputting, by the interface unit of the device, the overall view or the detail view.

### [Advantageous Effects]

According to the present specification, it is possible to implement the method and device for visually displaying the space in which the home appliances are disposed, checking the states of the home appliances disposed in the corresponding space, and controlling the operations of the home appliances.

In addition, according to the present invention, the states of the home appliances can be effectively checked and the home appliances can be managed in groups.

In addition, according to the present specification, since the states of the home appliances can be checked in detail for each space while comprehensively viewing the entire space, various control methods can be provided for the home appliances disposed in the spaces.

Effects of the present invention are not limited to the above effects, and various effects of the present invention can be easily derived from the configuration of the present invention.

### [BRIEF DESCRIPTION OF THE DRAWINGS]

FIG. 1 is a view illustrating a configuration of a device and server for monitoring and controlling states of home appliances according to one embodiment of the present invention.
FIG. 2 is a view illustrating a process in which a user terminal checks and controls the states of the home appliances via a server according to one embodiment of the present invention.
FIG. 3 is a view illustrating a process in which the user terminal directly checks and controls the states of the home appliances according to one embodiment of the present invention.
FIG. 4 is a view illustrating an interface displaying an overall view according to one embodiment of the present invention.
FIG. 5 is an enlarged view of the overall view according to one embodiment of the present invention.
FIG. 6 is a view illustrating a three-dimensional overall view according to one embodiment of the present invention.
FIGS. 7 to 9 are views illustrating states of home appliances belonging to a specific theme according to one embodiment of the present invention.
FIG. 10 is a view illustrating a detail view according to one embodiment of the present invention.
FIGS. 11 and 12 are views illustrating a method of displaying a home appliance according to one embodiment of the present invention.
FIGS. 13 and 14 are views illustrating a process of switching an overall view to a detail view according to one embodiment of the present invention.
FIGS. 15 and 16 are views illustrating the configuration and detailed screens of a bubble interface according to one embodiment of the present invention.
FIG. 17 is a view illustrating a configuration of a server according to one embodiment of the present invention.

### [DETAILED DESCRIPTION OF THE INVENTION]

Hereinafter, embodiments of the present invention will be described in detail with reference to the accompanying drawings so that those skilled in the art to which the present invention pertains can easily carry out the present invention. The present invention may be implemented in various different forms and is not limited to the embodiments described herein.

In order to clearly describe the present invention, parts not related to the description have been omitted, and the same or similar components are denoted as the same reference numerals throughout the specification. Hereinafter, some embodiments of the present invention will be described in detail with reference to exemplary drawings. In adding reference numerals to components in each drawing, the same components may have the same reference numerals as much as possible even when they are shown in different drawings. In addition, in the description of the present disclosure, when it is determined that a detailed description of a related known configuration or function may obscure the gist of the present disclosure, detailed description thereof may be omitted.

In the description of the components of the present invention, terms such as "first," "second," "A," "B," "(a)," "(b)," and the like may be used. These terms are only for the purpose of distinguishing one component from another component, and the nature, sequence, order, or the like of the corresponding component is not limited by these terms. When a certain component is described as being "connected," "coupled," or "joined" to the other component, the component may be directly connected or joined to the other component, but it should be understood that another component may be "interposed" between the components, or the components may be "connected," "coupled," or "joined" through another component.

In addition, the components may be sub-divided for convenience of description in implementing the present invention, but these components may be implemented within a single device or module, or a single component may be implemented by being divided into multiple devices or modules.

Hereinafter, a home appliance described herein is a device including an electronic product. The home appliance may be disposed in homes, offices, or the like and moved and disposed in other locations by people. Hereinafter, the present specification focuses on the control and monitoring of home appliances disposed within a home, but the present invention is not limited thereto, and may be applied to the monitoring and control of home appliances disposed in various spaces.

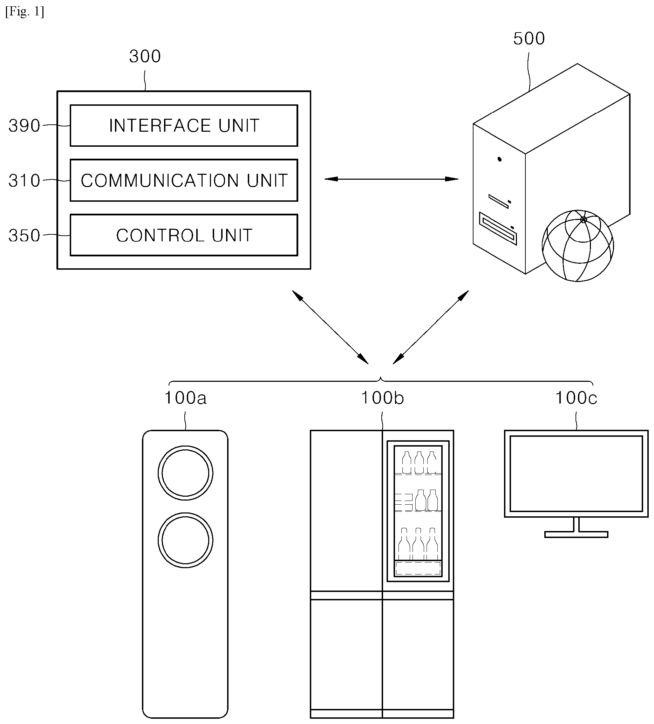

FIG. 1 is a view illustrating a configuration of a device and server for monitoring and controlling states of home appliances according to one embodiment of the present invention.

A user terminal 300 may be a smartphone, a tablet, a laptop, an iPad, or the like and may communicate with a server 500. In addition, in the present specification, a structure of the user terminal 300 or functions performed by the user terminal 300 may correspond to a structure or functions of a display device disposed in a specific home appliance. For example, a display module disposed on a door of a refrigerator may display a structure of a home or operating states of disposed home appliances. In this case, the refrigerator is a device for providing an overall view (a top view, a home view, a total view, a main view) or a detail view (immersive view). Hereinafter, for convenience of description, the user terminal is referred to as a home appliance that displays an overall view or a detail view, but the present invention is not limited thereto.

That is, embodiments of the present specification include both home appliances that are integrally formed with or detachably attached to a display module for displaying an overall view or a detail view, and home appliances that include a display module as a component. Both the home appliances and user terminals may be referred to as devices. That is, in the present specification, a device for displaying an overall view or a detail view corresponds to a user terminal or a home appliance including a display module.

Main components of the user terminal 300, which is an example of the device, include a communication unit 310, a control unit 350, and an interface unit 390. The communication unit 310 receives state information of home appliances 100a, 100b, and 100c from the home appliances 100a, 100b, and 100c or the server 500. In addition, the communication unit 310 transmits control instruction information for controlling operations of the home appliances 100a, 100b, and 100c to the home appliances 100a, 100b, and 100c or the server 500.

When an example of the device is a home appliance including a display module, the device may further include a functional unit that provides a unique function of the home appliance in addition to the communication unit 310, the control unit 350, and the interface unit 390.

For example, when the device is a refrigerator, the communication unit 310, the control unit 350, and the interface unit 390 correspond to components of the device together with the functional unit (e.g., including a compressor, a fan, and the like) that provides freezing/refrigerating functions, which are unique functions of the refrigerator, a door, etc. The display module may include the interface unit 390 and further include the communication unit 310 and the control unit 350. The display module may be disposed on the door or one side surface of the refrigerator.

For example, when the device is an oven, the communication unit 310, the control unit 350, and the interface unit 390 correspond to components of the device together with a functional unit that provides a heating function, which is a unique function of the oven. The display module may include the interface unit 390 and further include the communication unit 310 and the control unit 350. The display module may be disposed on the door or one side surface of the oven.

In this way, various home appliances may include the communication unit 310, the control unit 350, the interface unit 390, and the like to provide their original functions and display an overall view/detail view within a space. The control unit 350 generates an overall view or a detail view that includes a plan view of the space in which the home appliances 100a, 100b, and 100c are disposed, and the state information of the home appliances 100a, 100b, and 100c disposed within the space.

The interface unit 390 visually outputs the overall view or the detail view. The interface unit 390 may include a display module. In addition, the interface unit 390 may process user inputs, such as touch, drag, and the like, in addition to a touch module.

The home appliances 100a, 100b, and 100c disposed within a home may transmit their operating states to the server 500 or the user terminal 300. When the operating states are transmitted to the server 500, the user terminal 300 may check the operating states of the home appliances 100a, 100b, and 100c disposed within the home through the server 500.

Meanwhile, the server 500 or the user terminal 300 may check the states of the home appliances disposed within the home together with spatial information. The user terminal 300 may store spatial information or acquire spatial information through the server 500.

For example, when home appliances are disposed within a home, the user terminal 300 may visually provide the spatial structure and the states of the home appliances disposed within each space. in this way, visually provided images may be generally classified into an overall view (a top view, a home view, a total view, a main view) and a detail view (immersive view).

Switching between the overall view and the detail view may be performed by touching or selecting a specific area displayed on the user terminal. The control unit 350 may generate a detail view that displays all spaces (e.g., a bedroom, a home office, a living room, a kitchen, a utility room, and the like) matching the specific area selected by touching or the like. As a result, the interface unit 390 may display detail views of all spaces of the selected specific area (e.g., the entire living room, the entire master bedroom, the entire utility room, etc.). In this case, the control unit 350 can provide an animated effect that enlarges a corresponding area of the overall view and displays the detail view during the switching from the overall view to the detail view.

For example, when the master bedroom is selected in the overall view, the control unit 350 may control the interface unit 390 by generating a detail view so that the area of the master bedroom is gradually enlarged in the overall view and a detail view of the master bedroom is displayed.

The overall view displays all spaces and may be displayed in two-dimensional (2D) or three-dimensional (3D) format. The detail view may display an enlarged view of a specific space, with the 3D format of the space preferentially displayed. Alternatively, the detail view may also be displayed in 2D format.

The overall view displays all spaces, but a partially enlarged view may be provided according to the situation. For example, the overall view may be displayed upon initial loading, and when the user enlarges a portion of the overall view, a partially enlarged view of the overall view may be displayed on the user terminal. Conversely, upon initial loading, only a portion of the overall view may be displayed in an enlarged format, and when the user reduces the size of the partially displayed overall view, a reduced overall view may be provided.

In addition, the overall view may include at least two separated spaces in the plan view of the space or an enlarged view of the two or more separated spaces.

Here, the "separated spaces" refer to physical spaces separated by a wall or a door. As another example, the "separated spaces" also refer to functional spaces separated by home appliances disposed in the space.

The operating states of home appliances may be displayed in the overall view or the detail view.

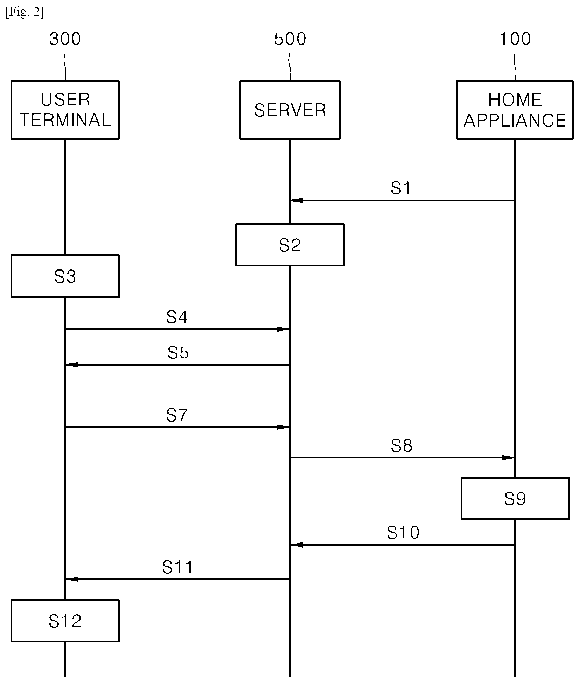

FIG. 2 is a view illustrating a process in which a user terminal checks and controls the states of the home appliances via a server according to one embodiment of the present invention.

Home appliances 100 transmit state information on current operating statuses, changes in operations, and the like to the server 500 (S1), and the server 500 stores the information (S2). Alternatively, the home appliances 100 may transmit state information of other home appliances on behalf of the other home appliances. For example, a result of monitoring the state of each home appliance through a moving robot cleaner may be state information, and the robot cleanser may transmit the state information to a server or a user terminal.

When a problem occurs with a specific home appliance, the robot cleaner (having a camera) may move to capture an image of the corresponding area and transmits a video or image to the server or the user terminal, thereby displaying the problem situation of the home appliance on a screen of the user terminal 100. In addition to the robot cleaner, adjacent home appliances may capture the operating states of other home appliances.

When the user terminal 300 wants to execute an application (S3) to display an overall view, the user terminal 300 requests the server 500 for the states of the home appliances 100 (S4). The server 500 transmits the state information of the home appliances to the user terminal 300 (S5). The user terminal 300 displays the state information of the home appliances (S6).

Then, the user terminal 300 transmits control instruction information to the server 500 to control the states of the home appliances (S7). The server 500 transmits the control instruction information to the home appliance 100 (S8). The home appliance 100 operates according to the received control instruction information (S9) and provides control result information to the server 500 (S10). Then, the server 500 transmits the control result information to the user terminal 300 (S11), and the user terminal displays the control result information of the home appliance 100 (S12).

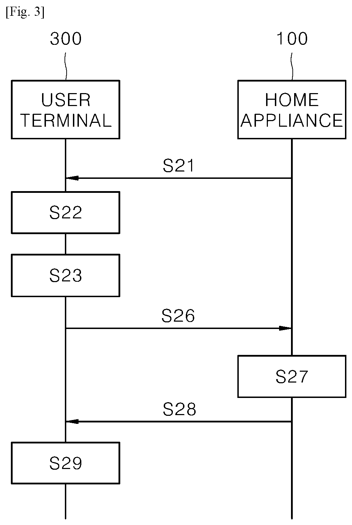

FIG. 3 is a view illustrating a process in which the user terminal directly checks and controls the states of the home appliances according to one embodiment of the present invention.

The home appliances 100 transmit state information on their current operating statuses or changes in operations to the user terminal 300 (S21), and the user terminal 300 stores the transmitted state information (S22).

When the user terminal 300 wants to execute an application (S23) to display the overall view, the previously stored state information is displayed.

Then, the user terminal 300 transmits control instruction information to the home appliance 100 to control the states of the home appliances (S26). The home appliance 100 operates according to the received control instruction information (S27) and transmits control result information to the user terminal 300 (S28), and the user terminal displays the control result information of the home appliance 100 (S29).

FIGS. 2 and 3 focus on the user terminal, but the description of the user terminal may be applied to various home appliances including a display module. That is, in addition to an iPad, a laptop, a computer, and a smartphone, a refrigerator or oven with a touchpad coupled, a TV that enables remote control input or touch input, and the like are all devices of the present invention.

In FIGS. 2 and 3, each home appliance may transmit state information thereof in real time to the server 500 or the user terminal 300. Alternatively, the home appliances may transmit state information according to a predetermined time schedule.

For example, home appliances with high data variability (e.g., a washing machine, a cooking apparatus, or the like) may transmit state information to the server 500 or the user terminal 300 in real time.

Meanwhile, home appliances with low data variability (e.g., a refrigerator) may transmit state information to the server 500 or the user terminal 300 together with a trigger when a specific event occurs.

This may be determined according to power or data transmission efficiency, and a transmission cycle and method may vary depending on a home appliance, a network environment, a setting method, etc.

In this way, the user terminal 300 may display state information, control, and operation result information of the home appliance. Hereinafter, the process of displaying the states of home appliances disposed within a space will be described.

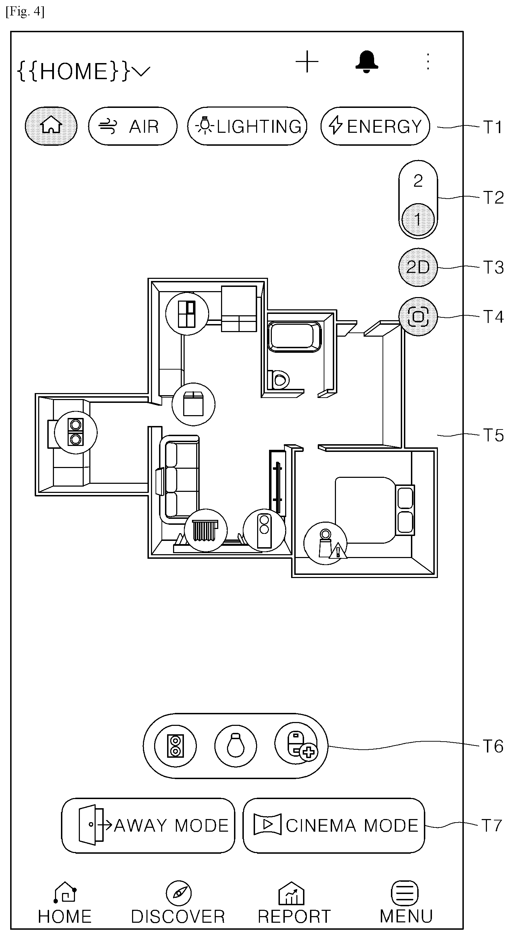

FIG. 4 is a view illustrating an interface displaying an overall view according to one embodiment of the present invention. The overall view may be referred to as a top view, a home view, etc.

The overall view includes an interface related to the structure of a home space and the state or control of each home appliance. The overall view may be generated by the server 500 and provided to the user terminal 300, and the user terminal 300 may generate a map.

The overall view may display a space in the form of a two-dimensional or three-dimensional plan view. Various parts of the interface displaying the overall view are as follows.

In the overall view, home appliances are disposed as icons within circles. By tapping the corresponding icons, the home appliances may be controlled, or the states thereof may be checked.

T1 is an interface related to a theme chip. When a home appliance is included in the corresponding theme, T1 is provided, and when selected, additional information is provided together with the home appliances belonging to the corresponding theme in the area of the plan view. Themes such as air, lighting, and energy may be provided.

That is, the overall view may display the entire configuration of the space in two- or three-dimensional format. In this case, the user terminal 300 may group home appliances disposed in the space into one or more themes when displaying the overall view and include a selectable interface for each theme. The themes may be grouped based on the type of home appliance and newly grouped by the user.

For example, when home appliances used for focusing on a specific task (e.g., lighting, an air conditioner, a TV, or the like) are included in a group, the corresponding group may also be presented as a theme.

T2 is an interface for selecting a floor. T2 is provided when the plan view has two or more floors.

T3 is a 2D/3D selection (2D/3D selection), allowing the user to select a view type for viewing the plan view, and upon entry, the view is provided in 2D format.

T4 is an interface for returning to the full screen and provided when enlarging, reducing, or rotating the area of the plan view, and the selection of the corresponding button returns the user to the home screen.

T5 is an interface for displaying the area of the plan view. In the area of the plan view, furniture and products disposed on the plan view is provided, and a product icon is also displayed in the overall view. The product icon also provides state information of the product.

T6 displays a list of undisposed devices, and home appliances that cannot be disposed or are not yet disposed on the plan view are displayed as icons.

T7 is an interface for listing smart routines, and among the smart routines stored by the user, routines that require direct execution are provided.

The overall view of FIG. 4 may be enlarged in various ways to provide a detail view. In addition, each view may be provided in three-dimensional format.

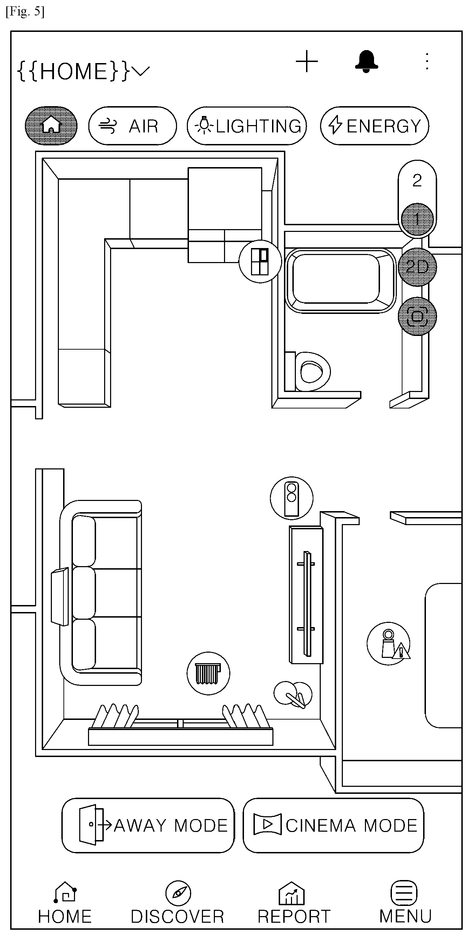

FIG. 5 is an enlarged view of the overall view according to one embodiment of the present invention. This is an example in which the user enlarges a specific space in the overall view of FIG. 4.

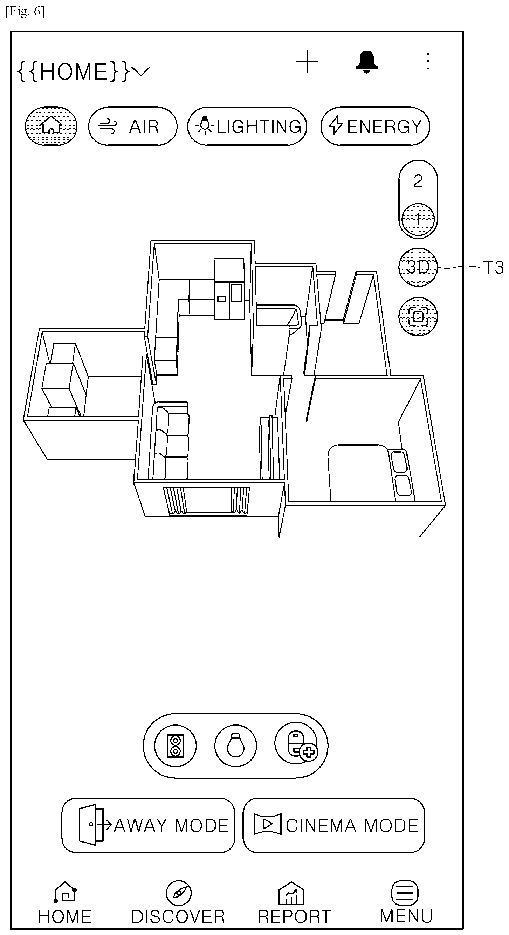

FIG. 6 is a view illustrating a three-dimensional overall view according to one embodiment of the present invention. When a user touches an area indicated by T3 in FIG. 4, the view may be switched between the two-dimensional- and three-dimensional format.

In this way, the overall view displayed on the user terminal 300 allows the user to check locations and operating states of each home appliance.

An area indicated by T1 in FIG. 4 may display home appliances categorized by a specific theme or display the states of home appliances belonging to the corresponding theme.

As described in FIGS. 4 to 6, the overall view needs to display the entire space, and names for each space may be assigned and displayed automatically or manually.

For example, when a user names a specific room "home office," the name of the corresponding space may be displayed in the overall view. When a specific name is not set, the overall view may display a name automatically assigned to each space or may not display the name.

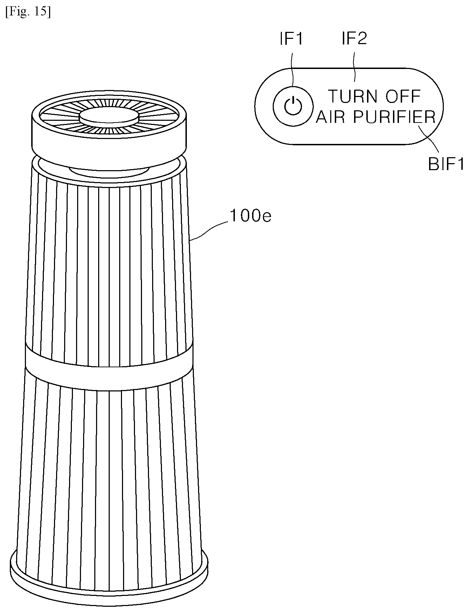

Since the overall view displays multiple home appliances, when distances between home appliances are short or the home appliances are disposed adjacent to each other within a specific space, the home appliances may be displayed to overlap each other. In this case, among the home appliances, appliances with information that the user needs to check may be displayed preferentially. In addition, when a bubble interface (see FIG. 15) to be described below is displayed among the home appliances and the bubble interface is selected by touch or other ways, the control unit 350 generates a detail view of the space in which the home appliance is disposed and controls the interface unit 390 to display the detail view.

In addition, in the overall view or the detail view, a specific home appliance may be newly disposed and registered, or home appliances may be removed, and this information may be immediately updated, displaying any changes in both the overall view and the detail view.

When a touch input that expands the space occurs in the overall view or the detail view, as a distance between overlapping home appliances increases, the individual home appliances may be displayed.

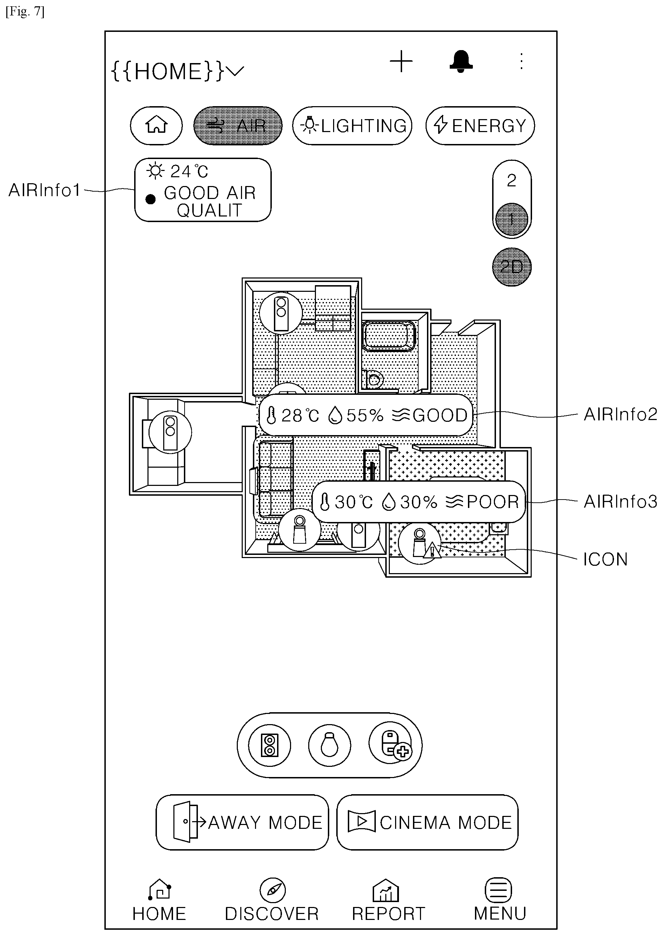

FIGS. 7 to 9 are views illustrating states of home appliances belonging to a specific theme according to one embodiment of the present invention. Themes may be grouped based on functions provided by the home appliances, the amount of energy consumed by the home appliances, etc. For example, the themes may include one or more of an air theme, a lighting theme, and an energy theme. Alternatively, a user may generate a specific theme and register home appliances belonging to the corresponding theme. The theme generated by the user is referred to as a user theme.

The control unit 350 of the user terminal 300 may control the operations of two or more home appliances included in a selected theme or generate an overall view displaying state information of two or more home appliances.

For example, when the "air" theme is selected on the user terminal 300, as illustrated in FIG. 7, information related to dehumidification, heating/cooling, and air purification, such as temperature, humidity, and air quality, may be displayed in the overall view.

When the air theme of FIG. 7 is selected, air information corresponding to a space, such as AIRInfo1, AIRInfo2, and AIRInfo3, may be displayed. When there are two or more devices capable of collecting air-related information in a single space, minimum and maximum values in each information category may be displayed. Additionally, outdoor air information may also be displayed when the air theme is selected.

The air quality may be classified as good, moderate, or poor depending on the air quality range, and when the air quality information is the same, it may be displayed in the same color, and when the air quality information differs, it may be displayed in a color distinguishable from the above color. For example, air quality categories may be divided into good/moderate/poor, and when the air theme is selected, good, moderate, or poor air quality may be displayed in the overall view for each space. In this case, the user terminal 300 may generate an overall view so that spaces with "good" air quality are displayed in color A, and spaces with "poor" air quality are displayed in color B.

In this case, the user terminal 300 may link colors A and B to a colors used by an air purifier disposed in the space to display air quality. For example, it is assumed that a home appliance disposed in a space displays good air quality in blue, moderate air quality in green, and poor air quality in red.

The user terminal 300 may integrate the air quality display colors of the air purifier and the space by applying the blue/green/red colors to display the air quality in the space in color.

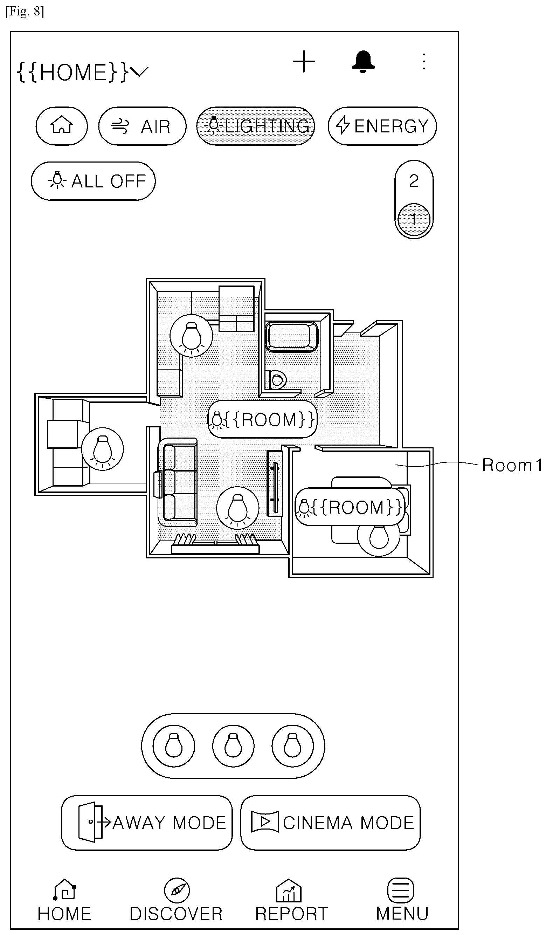

In addition, when the "lighting" theme is selected on the user terminal 300, as illustrated in FIG. 8, a lighting state may be displayed in the overall view. The control unit 350 may generate an overall view that displays different colors for each space depending on whether the lighting in each space is turned on or off. For example, as illustrated in FIG. 8, since a space marked by R1 has lighting turned off, the control unit 350 may display the corresponding space darkly. Since lighting in other spaces is turned on, the control unit 350 may generate an overall view that displays all spaces except R1 brightly.

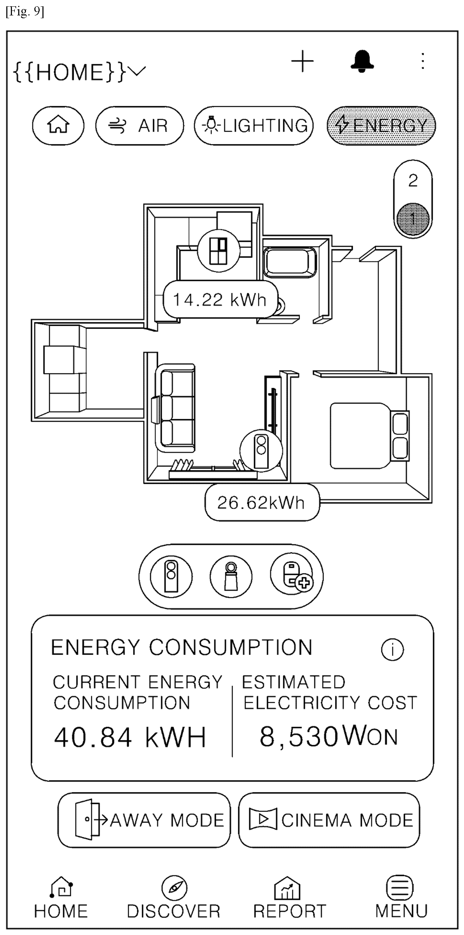

In addition, when the "energy" theme is selected on the user terminal 300, as illustrated in FIG. 9, the amount of energy consumed by each home appliance may be displayed in the overall view. The control unit 350 may generate an overall view that displays the energy consumption of each home appliance, provided that the home appliances measure energy consumption. FIG. 9 illustrates an example in which the energy consumption of two home appliances is displayed.

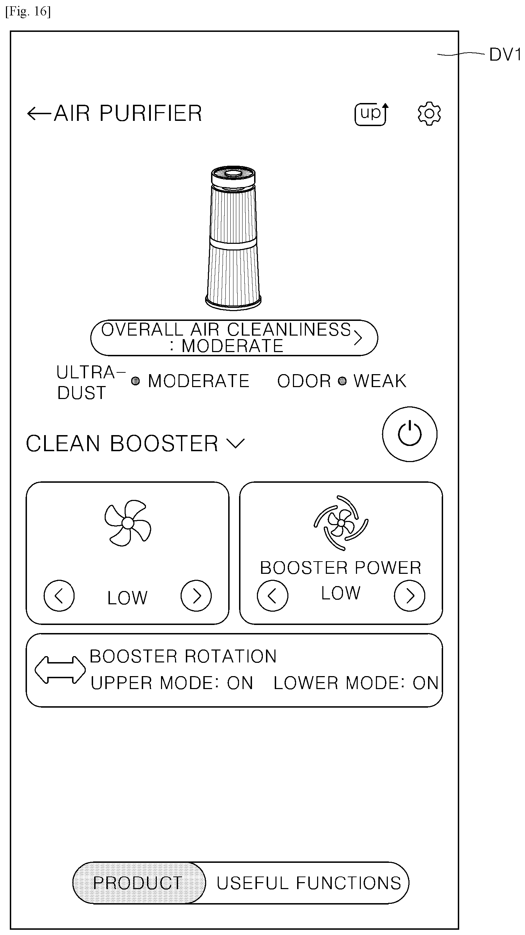

When an icon for a specific home appliance or a usage amount of the specific home appliance is selected in FIG. 9, the control unit 350 may generate a home appliance control screen to reduce the energy consumption of the corresponding home appliance. For example, the control unit 350 may display detailed information for each device, such as DV1 of FIG. 16, which will be described below.

Subspaces that constitute a space, such as a bedroom, a living room, or the like, may have visual limitations in checking the detailed operations of home appliances in the overall view. Accordingly, according to one embodiment of the present invention, the state and operation control of home appliances in each space are enabled through the detail view.

As described in FIGS. 7 to 9, when the specific theme is selected, the operations of home appliances belonging to the corresponding theme may be simultaneously controlled perform operations, including turning on or off. In FIG. 8, when the lighting theme is selected, the control unit 350 may generate the overall view to include an interface, referred to as an "All Off" interface, which allows all home appliances to be turned on or off.

Depending on the characteristics of the home appliances included in the theme, specific functions may be filtered, or information provided by home appliances in the corresponding category may be displayed in the overall view.

In the air theme, each home appliance may collect data, such as temperature, air quality, humidity, and the like, to determine the overall air cleanliness. In the air theme, all-off/all-on modes may be applied, and when only some home appliances are turned on, the all-off interface may be displayed in the overall view.

For the lighting theme, information on whether the lighting is turned on in the corresponding space may be provided, and an interface for turning on or off all lights in the space, such as a "Turn All Off" or "Turn All On," may be included and displayed in the overall view.

For the energy theme, energy consumption may be provided. Information, such as, current energy consumption, estimated electricity cost, and the like, may be displayed, and such information may be calculated for each appliance or for all appliances within the theme and displayed as illustrated in FIG. 9.

When a specific space is selected in the overall view of the user terminal 300, a detail view or an immersive view is provided for the corresponding space.

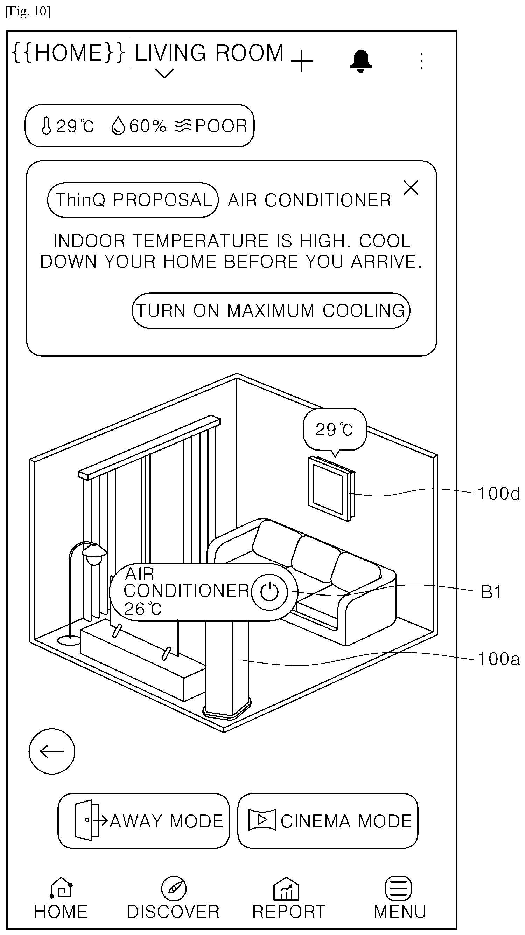

FIG. 10 is a view illustrating a detail view according to one embodiment of the present invention.

When a user touches the living room in the overall view displayed on the user terminal 300 of FIG. 4, a detail view, as illustrated in FIG. 10, is displayed, displaying temperatures detected by an air conditioner 100a and a wall-mounted air conditioner 100b, which are disposed in the living room.

The operation of the air conditioner may be turned off or on by selecting a power button B1 of the air conditioner 100a displayed on the user terminal 300.

For example, the detail view is an enlarged view of a specific space when a specific area within the overall view is touched. When the specific space is selected in the overall view and a home appliance is present in the corresponding space, the user terminal 300 may display a detail view of the corresponding space. Alternatively, when no home appliance is present, the detail view may not be provided. Alternatively, even when no home appliance is present, the detail view may be provided, and an interface for encouraging the user to register the home appliance may be displayed in the detail view.

The overall view may display icons representing home appliances, and the detail view may display the home appliances in 3D animation format.

Alternatively, the overall view and the detail view may display different information or different types of information according to a size difference.

In addition, the overall view may display all home appliances identically, and the detail view may display icons or the like based on the priority of each home appliance.

Alternatively, in the overall view, based on a specific environment or home appliances that generate notification, the corresponding home appliances may be displayed with priority or displayed in a larger size.

That is, when generating the overall view or the detail view, the control unit 350 of the user terminal 300 may display exteriors of multiple home appliances differently depending on the priority set for the home appliance, the priority of the operations of the home appliances, or the generation of a notification message from the home appliance. For example, FIG. 10 illustrates a state in which a bubble interface related to the air conditioner 100a, which provides a greater function in changing air temperature, is displayed.

As an example of displaying a detail view, the internal structure and arrangement of home appliances may be displayed at an angle that obscures the door, as illustrated in FIG. 10. In this case, the detail view may be disposed in a direction of movement from the outside to the corresponding space. However, the detail view may be disposed according to various criteria, such as a direction in which rooms are visible, a direction in which large home appliances are displayed in the back, or a direction in which the space is viewed toward the walls, based on the arrangement of home appliances. For example, according to the detail view settings, the detail view may be determined according to various criteria, such as a view entering the space through a door from the outside, a view looking through a window, a view looking in front of a window, etc.

Meanwhile, when home appliances and a user terminal communicate with each other, it can be seen that the home appliances have approached the user terminal 300. In this case, the user terminal 300 may receive a predetermined signal transmitted by the home appliance, and the user terminal 300 may generate and display a detail view of the space in which the corresponding home appliance is disposed.

Alternatively, the user terminal 300 may identify nearby home appliances. Even in this case, the user terminal 300 may generate and display a detail view of the space in which the identified home appliances are disposed.

For example, the user terminal 300 may measure distances to the home appliances or determine strengths of signals transmitted by the home appliances. In addition, the user terminal 300 may use the signal strength or measured distance information to display a detail view of the space in which the home appliances are disposed.

In the above examples, the state information of the home appliances displayed in the overall view or the detail view may include one or more of icons representing the home appliances, operating states of the home appliances, on/off states of the home appliances, information acquired by sensors included in the home appliances, information related to upgrade progress, or notification information on the home appliances. The state information may be provided in the form of icons.

In addition, a bubble-shaped interface may be disposed adjacent to each home appliance, and the corresponding interface may include the name of the home appliance, sensing information detected by the home appliance (e.g., temperature), an interface for controlling the home appliance (e.g., an on/off button), etc.

The bubble-shaped interface may always be displayed in the overall view or the detail view. Alternatively, the bubble-shaped interface may only be displayed for a home appliance specifically selected on the user terminal.

When the bubble interface of the specific home appliance displayed on the user terminal in the overall view is touched, the user terminal 300 may display a detail view of the space in which the corresponding home appliance is disposed.

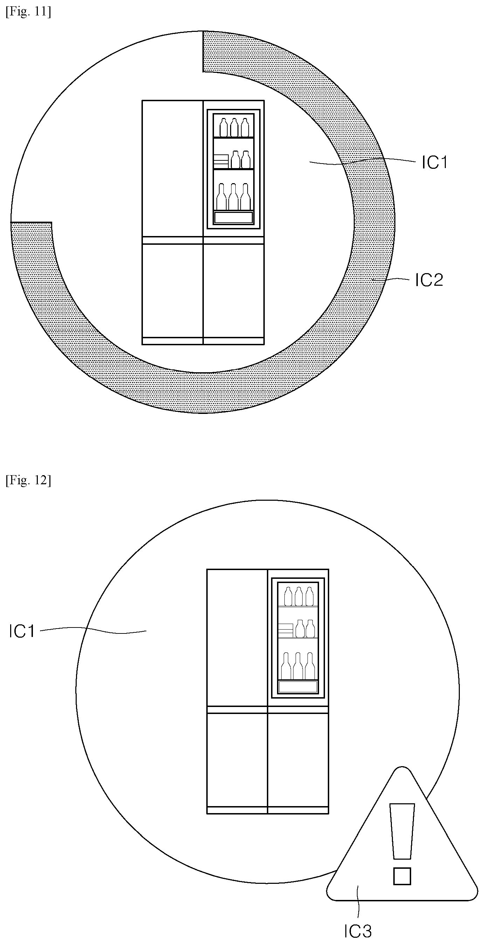

FIGS. 11 and 12 are views illustrating a method of displaying a home appliance according to one embodiment of the present invention.

Various information on home appliances disposed in each space may be displayed in the overall view or the detail view.

As illustrated in FIG. 11, a device icon IC1, which visually indicates the type of home appliance, and a progress icon IC2, which indicates the operating state of the home appliance, may be displayed in the overall view or the detail view. A circular progress icon IC2 indicates completion, 100% progress, etc.

The operating state refers to information related to, for example, the time an air conditioner or a refrigerator circulates refrigerant to perform cooling/freezing operations, the time a washing machine runs a specified washing cycle, the time an oven heats food, etc. According to FIG. 11, the user may intuitively check the operating state or progress of a task of a home appliance in the overall view or the detail view.

In addition, as illustrated in FIG. 12, the device icon IC1 that visually indicates the type of home appliance and a notification icon IC3 that indicates a task to be performed for the home appliance may be displayed in the overall or detail view.

In summary, the icons displayed in the overall or detail view may include a main icon representing the home appliance and icons disposed around the main icon to indicate the operating state, as illustrated in FIG. 11.

The icons displayed in the overall or detail view may include a main icon representing the home appliance and icons disposed around the main icon to indicate important notifications, such as malfunctions, updates, filter replacement, communication failures, and the like, as illustrated in FIG. 12. The icons representing notification may be displayed above the icons in FIG. 11.

In addition, the main icon representing the home appliance may also visually indicate the operating state of the home appliance. For example, when an icon for a washing machine/drying machine is displayed in the overall or detail view and only the drying machine is in operation, an animation effect can be displayed only on the drying machine.

In addition, when the lighting of an air purifier changes depending on the distribution of fine dust in the air or even when the power/wind direction of the air conditioner changes, the animation effect can be applied to the icons so that the lighting may be synchronized with the actual operation of the home appliance.

According to the embodiment of the present invention, the user terminal may suggest tasks to be performed by home appliances disposed in each space through the overall or detail view.

For example, in the example of FIG. 7, when the air quality in a specific space is indicated as poor, touching the corresponding space or the icon for the home appliance in the overall view may activate an operation course for the home appliance appropriate for the space or turn on the corresponding home appliance.

The detail view may provide visualized information for each space.

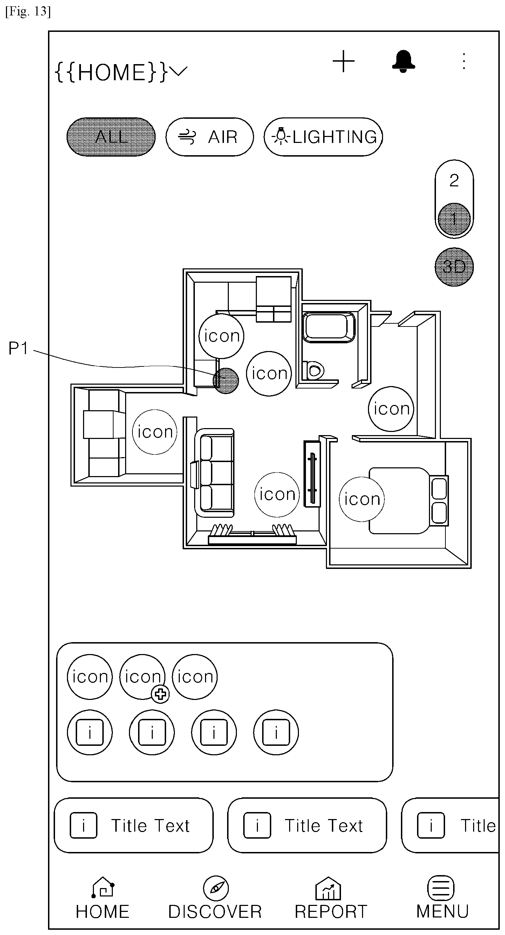

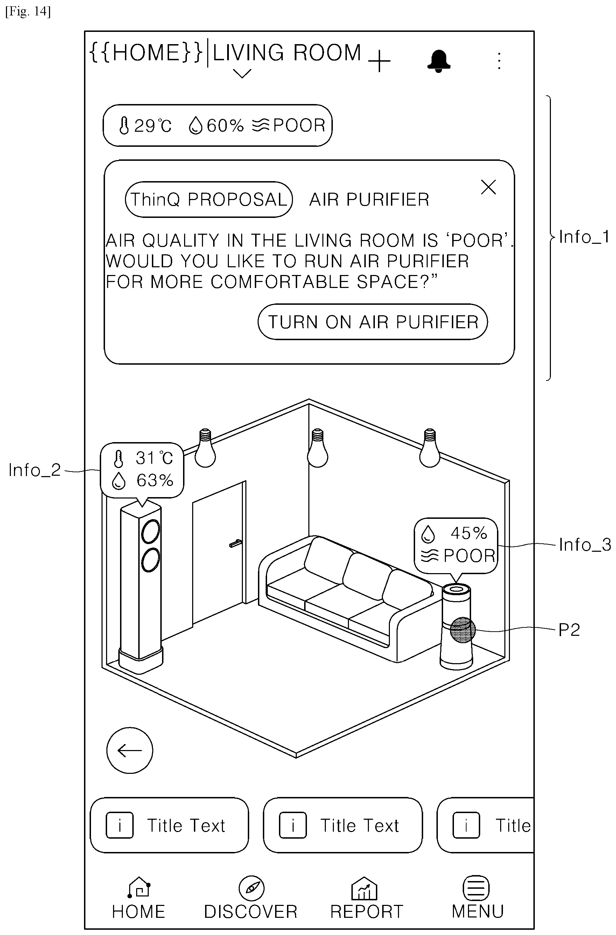

FIGS. 13 and 14 are views illustrating a process of switching an overall view to a detail view according to one embodiment of the present invention.

When a specific space (e.g., P1) is selected in the overall view of FIG. 13, a detail view for the corresponding space is displayed, as illustrated in FIG. 14. When a specific area is selected in the overall view in a state in which the overall view is displayed, the interface unit 390 provides the corresponding location information to the control unit 350. The control unit 350 may generate the detail view corresponding to the selected area.

As described above, a detail view viewed in the direction of entering a specific space may be displayed, but the present invention is not limited thereto.

As illustrated in FIG. 14, the detail view includes the structure of the area and detailed state information Info_2 and Info_3 of the home appliances disposed in the area. In addition, information (temperature, air quality, etc.) on the corresponding area may also be displayed in the detail view, as in Info_1.

The detail view of FIG. 14 may display the furniture and products disposed in the entered space as a 3D image. The detail view may include current statuses, sensed information, and operation information of each home appliance, and information on product effects according to the operating course state of the home appliance to allow the user to quickly recognize the state visually. When generating the detail view, the control unit 350 may display the name of the corresponding space, and for example, the name of the space is set by the user or assigned automatically.

In the detail view, according to the type of home appliances disposed in the corresponding space, information displayed in the previously described air theme, lighting theme, or energy theme may be displayed in Info_1. When multiple home appliances are disposed and belong to two or more themes, the control unit 350 may display information on a specific theme in Info_1 based on the importance of the information provided by the home appliances, the urgency of user confirmation, etc.

For example, it is assumed that the detail view includes both home appliances belonging to the energy theme and home appliance belonging to the lighting theme. When the energy consumption of the home appliances belonging to the energy theme increases significantly compared to normal energy consumption, the control unit 350 may display information related to the energy theme in Info_1.

As another example, it is assumed that both the energy theme and the air theme are included in the detail view. When the energy consumption of the home appliances belonging to the energy theme corresponds to the normal usage but the air quality is very poor, the control unit 350 may display information related to the air theme in Info_1.

As illustrated in Info_1, information on the corresponding area may include context-specific suggestions and recommended action cards related to products disposed in the space. For example, the situation-specific proposal refers to a suggestion for the user to control a home appliance so as to change the situation within the space to a normal range, when conditions such as air quality, lighting state, or energy consumption in the space deviate from the normal range. In FIG. 14, information indicating that the air quality is poor and that the air purifier needs to be turned on may be displayed.

When a user selects an adjacent area P2 of a specific home appliance, the control unit 350 generates a screen for checking the state of the corresponding home appliance in detail, and the interface unit 390 may display detailed information.

Meanwhile, the control unit 350 of the user terminal 300 may display a bubble interface adjacent to a specific home appliance when generating an overall view or a detail view.

The bubble interface includes one or more of an interface for displaying the state of the home appliance and an interface for controlling the home appliance.

FIGS. 15 and 16 are views illustrating the configuration and detailed screens of a bubble interface according to one embodiment of the present invention.

A bubble interface BIF1 may be disposed around the air purifier 100e in the overall view or the detail view. The bubble interface includes an interface IF1 that may display the current status of the air purifier or also indicate on/off operation, and an interface IF2 that displays the name and current status information of the home appliance.

When a user selects the bubble interface, the user terminal 300 may display a detail screen DV1 of the corresponding product (e.g., an air purifier). The detail screen may also be displayed when an adjacent area of a specific home appliance is selected in FIG. 14.

That is, when the bubble interface is selected, the control unit 350 of the user terminal 300 may generate a detail screen for the home appliance and display the generated detail screen on the interface unit 390.

The bubble interface may be displayed in various ways, in addition to the configuration of FIG. 15. For example, when a home appliance is in operation, the control unit 350 may generate state information and a bubble interface that includes information on the remaining time until the operation ends or the elapsed time since the operation began. In addition, when there is information that the user needs to check about the corresponding home appliance, the control unit 350 may generate a bubble interface for displaying the corresponding information in the form of an alarm.

In addition, the bubble interface may provide an interface necessary for controlling the home appliance. For example, the control unit 350 may add an interface, such as IF1, which enables quick manipulation such as turning on or off the home appliance, to the bubble interface.

The information displayed on the bubble interface may be configured differently depending on the theme in which the corresponding home appliance is included.

For home appliances belonging to the air theme, the control unit 350 may generate a bubble interface including air-related information.

Since the detail view displays the spatial structure of a specific area within the overall space and the state of the home appliance, the control unit 350 may generate a detail view including a bubble interface for each specific home appliance when switching the overall view to the detail view.

The control unit 350 may cause the bubble interface displayed on the overall view or the detail view to disappear when a home appliance is tapped or when an area other than the bubble interface is tapped.

The bubble interface may provide customized information necessary for using the home appliance. For example, the control unit 350 may include a setting value of a home appliance, which can optimize the state of a space or the home appliance, in the bubble interface. In this case, the control unit 350 displays a notification on the bubble interface so that the user may check a detailed setting value of the home appliance.

In addition, the bubble interface may provide information indicating an error of a home appliance or the replacement of a specific component. For example, the control unit 350 may check an abnormal refrigerant level in an air conditioner and filter replacement or cleaning state of an air purifier. In this case, the control unit 350 displays a notification on the bubble interface so that the user may proceed with a process, such as replacing or repairing a component of a home appliance.

In summary, the control unit 350 may determine the priority of sensing information acquired by the home appliance or the operation to be performed by the home appliance when generating an overall view or a detail view to generate a bubble interface for a home appliance with the highest priority.

The task performed by the control unit 350 of the user terminal 300 to generate the overall view or the detail view may also be performed by the server 500. In this case, when the overall view or detail view generated by the server 500 is transmitted to the user terminal 300, the user terminal 300 transmits information on a point where a touch input, such as a touch or drag, occurs to the server 500 and receive information, which is newly changed based on the transmitted information, from the server 500.

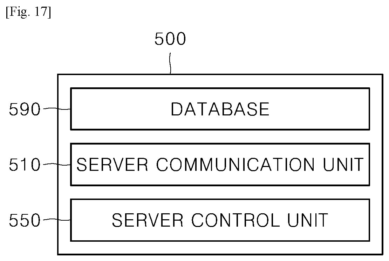

FIG. 17 is a view illustrating a configuration of a server according to one embodiment of the present invention.

The server 500 includes a database 590 that receives and stores account information related to the user terminal 300, information on home appliances disposed in the space managed by the user terminal 300, and environmental data, such as weather, temperature and humidity, fine dust, and the like, from the outside. In addition, the server 500 includes a server communication unit 510 for transmitting and receiving data with the user terminal 300, an external weather server, etc.

The server control unit 550 generates information necessary for the user terminal 300 to display an overall view or a detail view. The server control unit 550 and the control unit 350 of the user terminal 300 may collaborate to generate the overall view and the detail view.

The server control unit 550 generates information necessary for displaying the overall view and the detail view using information stored in the database 590 and various collected information.

The server 500 may store various data generated by home appliances, user data provided by the user terminal 300, and the like in the database 590.

In addition, the server 500 may receive and store various information (sensing information, operation history information, and the like) generated during the operation of each home appliance. During this process, some home appliances may transmit data to the server 500 via the user terminal 300.

In addition, the server 500 may control the operation of the home appliance by transmitting control instruction information transmitted from the user terminal 300 to the home appliance. This corresponds to a case in which communication between the user terminal 300 and the home appliance 100 passes through the server 500, as described in FIG. 2.

When the control unit 350 of the user terminal 300 or the server control unit 550 of the server 500 generates an overall view or a detail view, the operating state information of each home appliance, current time information (day and night), weather information, and the like may be reflected. In addition, the control unit 350 of the user terminal 300 or the server control unit 550 of the server 500 may generate a detail view, such as rotating the view of the space through the camera control effect.

Meanwhile, when executing an app to display an overall view on the user terminal 300, the user terminal 300 may output a card message recommending the operation of a specific home appliance before displaying the overall view.

For example, since information sensed by home appliances may be transmitted to the user terminal 300, the user terminal 300 may determine whether indoor temperature is higher or lower than a reference temperature or whether the air quality is very poor.

In this case, the control unit 350 may suggest cooling or heating for an appropriate temperature or display a pop-up card message on the interface unit 390 to turn on an air conditioner or an air purifier.

Even though all components constituting the embodiments of the present invention have been described as being coupled or coupled and operated, the present invention is not necessarily limited to these embodiments, and one or more of all components may be selectively coupled and operated without departing from the scope of the present invention. In addition, each of the components may be implemented as a single, independent hardware, but some or all of the components may be selectively coupled and implemented as a computer program having program modules that perform some or all of the combined functions of one or more hardware units. The codes and code segments constituting the computer program can be easily inferred by those skilled in the art. Such a computer program may be stored in a computer-readable storage medium and read and executed by a computer, thereby implementing the embodiments of the present invention. The storage media for computer programs include magnetic recording media, optical recording media, and storage media including semiconductor recording devices. In addition, a computer program implementing the embodiments of the present invention includes program modules transmitted in real time through an external device.

The above description focuses on the embodiments of the present invention, but various changes and modifications may be made within the scope of those skilled in the art. Accordingly, it will be understood that these changes and modifications are included within the scope of the present invention as long as they do not depart from the scope of the present invention.

## Claims

1. A device comprising:
a communication unit configured to receive state information of a home appliance from the home appliance or a server;
a control unit configured to generate an overall view or a detail view including a plan view of a space in which the home appliance is disposed and state information of the home appliance disposed in the space; and
an interface unit configured to output the overall view or the detail view.

2. The device of claim 1, wherein the interface unit displays an overall configuration of the space as a two-dimensional or
three-dimensional overall view, and
the overall view includes an interface that groups the home appliances disposed in the space into one or more themes and enables theme-specific selection.

3. The device of claim 1, wherein the overall view includes at least two separated spaces in the plan view of the space or an enlarged view of the two or more separated spaces.

4. The device of claim 1, which is any one of a user terminal and a home appliance including a display module.

5. The device of claim 2, wherein the theme includes one or more of an air theme, a lighting theme, an energy theme, and a user theme, and
the control unit controls operations of two or more home appliances included in the selected theme or generates the overall view displaying state information of the two or more home appliances.

6. The device of claim 1, wherein the state information displayed by the overall view or the detail view includes at least any one of an icon representing the home appliance, an operating state of the home appliance, an on/off state of the home appliance, information acquired by a sensor included in the home appliance, information related to upgrade progress, and notification information related to the home appliance.

7. The device of claim 4, wherein the state information displayed by the overall view or the detail view indicates that an operating progress of the home appliance is displayed around an icon representing the home appliance, or an icon representing a notification message is displayed around the icon.

8. The device of claim 1, wherein, when generating the overall view or the detail view, the control unit differentially displays exteriors of multiple home appliances according to a priority set for the home appliance, a priority of the operation of the home appliance, or generation of a notification message from the home appliance.

9. The device of claim 1, wherein, when a specific area of the overall view is selected in a state in which the overall view is displayed,
the control unit generates the detail view corresponding to the selected area, and
the detail view includes a structure of the area and detailed state information of home appliances disposed in the area.

10. The device of claim 9, wherein the control unit generates the detail view that displays the entire space matching the selected specific area.

11. The device of claim 1, wherein the overall view or the detail view includes a bubble interface including the state information of the home appliances, and
when the bubble interface is selected, the control unit generates a detail screen for the home appliance and displays the detail screen on the interface unit.

12. The device of claim 11, wherein the control unit determines a priority of sensing information acquired by the home appliance or an operation to be performed by the home appliance when generating the overall view or the detail view to generate a bubble interface for a home appliance with a highest priority.

13. The device of claim 1, wherein the communication unit transmits control instruction information for controlling the operation of the home appliance to the home appliance or the server.

14. A method of visually displaying and controlling home appliances in a space, the method comprising:
receiving, by a communication unit of a device, state information of a home appliance from the home appliance or a server; generating, by a control unit of the device, an overall view or a detail view including a plan view of a space in which the home appliance is disposed and state information of the home appliance disposed in the space; and
outputting, by the interface unit of the device, the overall view or the detail view.

15. The method of claim 14, wherein the outputting of the overall view or the detail view includes displaying, by the interface unit, an entire configuration of the space as a two-dimensional or three-dimensional overall view, and
the overall view includes an interface that groups the home appliances disposed in the space into one or more themes and enables theme-specific selection.

16. The method of claim 14, wherein the overall view includes at least two separated spaces in the plan view of the space or an enlarged view of the two or more separated spaces.

17. The method of claim 14, wherein the device is any one of a user terminal and a home appliance including a display module.

18. The method of claim 15, wherein the theme includes one or more of an air theme, a lighting theme, an energy theme, and a user theme, and
the method further comprising: controlling, by the control unit, operations of two or more home appliances included in the selected theme or generating the overall view displaying state information of the two or more home appliances.

19. The method of claim 14, wherein the state information displayed by the overall view or the detail view includes at least any one of an icon representing the home appliance, an operating state of the home appliance, an on/off state of the home appliance, information acquired by a sensor included in the home appliance, information related to upgrade progress, and notification information related to the home appliance.

20. The method of claim 19, wherein the state information displayed by the overall view or the detail view indicates that an operating progress of the home appliance is displayed around an icon representing the home appliance, or an icon representing a notification message is displayed around the icon.

21. The method of claim 14, wherein the generating of the overall view or the detail view includes differently displaying, by the control unit, exteriors of multiple home appliances according to a priority set for the home appliance, a priority of the operation of the home appliance, or generation of a notification message from the home appliance when generating the overall view or the detail view.

22. The method of claim 14, further comprising, when a specific area of the overall view is selected in a state in which the overall view is displayed,
generating, by the control unit, the detail view corresponding to the selected area,
wherein the detail view includes a structure of the area and detailed state information of home appliances disposed in the area.

23. The method of claim 22, comprising generating, by the control unit, the detail view that displays the entire space matching the selected specific area.

24. The method of claim 14, wherein the overall view or the detail view includes a bubble interface including the state information of the home appliances, and
the method further comprises generating, by the control unit, a detail screen for the home appliance and displaying the detail screen on the interface unit when the bubble interface is selected.

25. The method of claim 24, further comprising determining, by the control unit, a priority of sensing information acquired by the home appliance or an operation to be performed by the home appliance when generating the overall view or the detail view to generate a bubble interface for a home appliance with a highest priority.

26. The method of claim 14, further comprising transmitting, by the communication unit, control instruction information for controlling the operation of the home appliance to the home appliance or the server.
